# EUROPÄISCHE PATENTSCHRIFT

(11) **EP 2 269 020 B1**
(45) Veröffentlichungstag und Bekanntmachung des Hinweises auf die Patenterteilung: **01.03.2017**
(21) Anmeldenummer: 09738025.7
(22) Anmeldetag: 20.04.2009
(51) Int. Cl.: G01L 9/00

(54) **DRUCKSENSOR**
PRESSURE SENSOR
CAPTEUR DE PRESSION

(30) Priorität: 28.04.2008 DE 102008021091
(43) Veröffentlichungstag der Anmeldung: 05.01.2011
(73) Patentinhaber: Epcos AG, 81669 München (DE)
(72) Erfinder: WOHLGEMUTH, Christian, 12249 Berlin (DE); THIELE, Peter, 12623 Berlin (DE)
(74) Vertreter: Epping - Hermann - Fischer
(86) Internationale Anmeldenummer: PCT/EP2009/054656
(87) Internationale Veröffentlichungsnummer: WO 2009/132981

(56) Entgegenhaltungen:
- WO-A-00/45143
- DE-A1-102005 045 380
- MOTOROLA: "Integrated Silicon Pressure Sensor On-Chip Signal Conditioned, Temperature Compensated and Calibrated" 1. Januar 2002 (2002-01-01), MOTOROLA SEMICONDUCTOR TECHNICAL DATA,, PAGE(S) 1 - 13 , XP007909192 das ganze Dokument
- THE ENGINEERING TOOLBOX: 'Coefficients of Linear Thermal Expansion' INTERNET CITATION, [Online] 11 Dezember 2013, Seiten 1 - 7, XP007922453 Gefunden im Internet: <URL:http://www.engineeringtoolbox.com/line ar-expansion-coefficient-d_95.html> [gefunden am 2013-12-11]

## Beschreibung

Aus den Druckschriften US 4,218,925, DE 10 2005 045 380, und US 4,543,832 sind Drucksensoren bekannt.

Es ist Aufgabe der vorliegenden Erfindung, einen Drucksensor anzugeben, der eine hohe Integrationsdichte aufweist.

Diese Aufgabe wird durch einen Drucksensor nach Patentanspruch 1 gelöst. Vorteilhafte Ausgestaltungen des Drucksensors sind Gegenstand von Unteransprüchen.

Es wird ein Drucksensor angegeben, der ein Substrat aufweist, das mit Leiterbahnen zur Kontaktierung von elektrischen Bauelementen versehen ist. Zur Aufnahme und Umwandlung einer mechanischen Messgröße oder einer elektrischen Zwischengröße in ein elektrisches Signal weist der Drucksensor ein Messelement auf. Zur weiteren Verarbeitung des von dem Messelement ausgegebenen elektrischen Signals weist der Drucksensor einen Signalwandler auf. Der Signalwandler dient beispielsweise dazu, das Signal des Messwandler zu verstärken sowie zur Berechnung einer Temperaturkompensierung sowie zur Standardisierung des Messsignals. Das Substrat des Drucksensors bildet zusammen mit einer ersten Membran einen ersten geschlossenen Hohlraum, der ein inertes Füllmedium, wie beispielsweise Öl, enthält.

Das Messelement des Drucksensors weist mit wenigstens einer Seite, die eine aktive Fläche umfasst, einen direkten Kontakt zu dem Füllmedium des ersten Hohlraums auf. Der Signalwandler ist bevorzugt als ungehäuster Chip (Die), der integrierte Schältkreise umfasst, auf dem Substrat des Drucksensors angeordnet. Der Signalwandler, ein Siliziumchip mit integrierten Schaltungen oder Schaltstrukturen, steht in einer bevorzugten Ausführungsform vorzugsweise mit einer Seite in direktem Kontakt zu dem Substrat des Drucksensors. Gegenüber gehäusten Chips, die beispielsweise als SMD Form vorliegen, weist der Signalwandler somit wesentlich geringere Abmessungen auf. SMD-Chips sind beispielsweise mit einem Kunststoff- oder Keramikgehäuse umgeben, wobei ein Siliziumchip mit integrierten Leiterbahnen im inneren an Außenkontakte gebondet ist. Durch die geringen Abmessungen des Siliziumchips kann der Signalwandler beispielsweise in einer Vertiefung des Substrats angeordnet werden.

In einer bevorzugten Ausführungsform ist der Signalwandler in einer Vertiefung des Substrats angeordnet.

Um den Signalwandler, der ein Siliziummaterial mit integriertem Schaltkreis umfasst, vor mechanischen Beschädigungen und schädlichen Umwelteinflüssen beziehungsweise vor Korrosion zu schützen, ist der Signalwandler wenigstens teilweise von einem elastischen beziehungsweise bevorzugt von einem weichelastischen Material umhüllt.

In einer weiteren Ausführungsform weist der Signalwandler wenigstens teilweise einen direkten Kontakt zu dem Füllmedium auf.

In einer bevorzugten Ausführungsform handelt es sich bei dem elastischen Material und dem Füllmedium um die gleiche Substanz.

Der erste Drucksensor weist in einer weiteren Ausführungsform zwischen der ersten Membran und dem Substrat in Teilbereichen eine Zwischenschicht auf. Die Zwischenschicht wird vorzugsweise mittels Löten oder Schweißen mit dem Substrat verbunden. Die Zwischenschicht ist vorzugsweise mit ihrem Wärmeausdehnungskoeffizienten an den Wärmeausdehnungskoeffizienten des Substrats angepasst. In einer bevorzugten Ausführungsform weist die Zwischenschicht die Form eines Rings auf, auf dem die erste Membran aufgebracht ist. In einer bevorzugten Ausführungsform enthält die Zwischenschicht Kovar.

Als Kovar werden Metalllegierungen bezeichnet, die einen geringen Wärmeausdehnungskoeffizienten aufweisen, der typischerweise geringer ist als der Koeffizient der meisten Metalle. Derartige Kovar-Legierungen weisen einen Wärmeausdehnungskoeffizienten im Bereich von ungefähr 5ppm/K auf. Durch die Zwischenschicht aus Kovar können die unterschiedlichen Wärmausdehnungskoeffizienten des Substrats, der Membran und eines Prozessanschlusses des Drucksensors ausgeglichen werden, so dass es hier zu möglichst geringen Verspannungen kommt.

Die Membran umfasst in einer bevorzugten Ausführungsform ein Metall, wobei sich hierbei Edelstahl besonders gut als Material für die Membran eignet.

In einer bevorzugten Ausführungsform weist die Membran eine strukturierte Oberfläche auf, die beispielsweise ein sich konzentrisch ausbreitendes Wellenmuster umfassen kann. Die Membran wird beispielsweise mittels Löten oder Schweißen mit der Zwischenschicht verbunden.

Um in einer weiteren Ausführungsform den relativen Druck eines Mediums bezüglich der Umgebungsatmosphäre zu messen, weist das Messelement des Drucksensors mit seiner Rückseite einen direkten Kontakt zu der Atmosphäre der Umgebung auf. Hierzu weist das Substrat des Drucksensors im Bereich seiner Rückseite des Messelements beispielsweise einen Durchbruch auf. Der erste Hohlraum ist vorzugsweise mittels des Messelements von der Atmosphäre der Umgebung getrennt.

In einer weiteren Ausführungsform ist es auch möglich, dass die Messung des Drucks des Relativmediums, wie beispielsweise Luft, mittels eines zweiten Messelements ermittelt wird.

In einer weiteren Ausführungsform dient der Drucksensor dazu, den Differenzdruck zwischen zwei Medien zu messen, die an dem Drucksensor anliegen. Hierbei bildet das Substrat mittels einer zweiten metallischen Membran einen zweiten geschlossenen Hohlraum, der ein inertes Füllmedium enthält. Bevorzugt sind der erste und zweite Hohlraum auf gegenüberliegenden Seiten des Substrats angeordnet.

Bei der Messung des Differenzdrucks weist das Messelement mit seiner Rückseite einen direkten Kontakt zu dem Füllmedium des zweiten Hohlraums auf. Mit der aktiven Seite des Messelements weist dieses einen direkten Kontakt zum Füllmedium des ersten Hohlraums auf.

In einer bevorzugten Ausführungsform umfasst das Substrat eine Keramik, die vorzugsweise mehrere Schichten umfasst. Hierbei kann es sich beispielsweise um eine HTCC (high temperature cofired ceramic), wie beispielsweise eine Aluminiumoxid-Keramik oder eine LTCC (low temperature cofired ceramic), wie beispielsweise eine Silizium-, eine Aluminum- oder eine Lithiumoxid-Keramik handeln.

Das Messelement und der Signalwandler des Drucksensors sind bevorzugt über Leiterbahnen des Substrats kontaktiert. Zur Kontaktierung des Signalwandlers werden vorzugsweise Bonddrähte verwendet.

Zur Kontaktierung des Drucksensors nach außen weisen die Leiterbahnen des Substrats wenigstens einen Bereich auf, der außerhalb des ersten und/oder zweiten Hohlraums angeordnet ist und von außen kontaktierbar ist. Dadurch kann das Signal des Signalwandlerbausteins direkt ausgegeben werden oder weiter verarbeitet werden.

Zur Befestigung des Drucksensors an einem mediengefüllten Rohr, dessen Druck ermittelt werden soll, weist der Drucksensor wenigstens an einer Seite einen rohrförmigen Anschluss auf. Mittels des rohrförmigen Anschlusses hat das zu messende Medium einen direkten Kontakt zur ersten oder zweiten Membran des Drucksensors. Bei einer Ausführungsform des Drucksensors zur Messung des Differenzdrucks zwischen zwei Medien, weist der Drucksensor auf den Seiten der Hohlräume jeweils einen Anschluss zur Befestigung an dem jeweiligen Rohr auf. Die Befestigung des Drucksensors an dem Rohr des zumessenden Mediums kann auch beispielsweise mittels Adapter zwischen dem Anschluss des Drucksensors und dem Rohr erfolgen.

Der Anschluss des Drucksensors ist vorzugsweise auf der Außenseite der ersten und/oder zweiten Membran angeordnet. Um eine vorzugsweise gasdichte Verbindung zwischen dem Anschluss und dem Drucksensor zu erreichen, ist der Anschluss beispielsweise mittels eines O-Ringes abgedichtet.

In einer Ausführungsform kann der Anschluss die Form eines Rohres, eines Gewindeanschlusses, einer Tülle oder auch die Form einer so genannten Schlaucholive aufweisen.

Bevorzugt eignet sich der Drucksensor zur Messung des Absolutdrucks oder des Relativdrucks eines Mediums beziehungsweise zur Messung des Differenzdrucks zwischen zwei Medien.

Die oben beschriebenen Gegenstände werden anhand der folgenden Figuren und Ausführungsbeispielen näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein. Elemente, die einander gleichen oder die die gleiche Funktion übernehmen, sind mit den gleichen Bezugszeichen bezeichnet.
- Figur 1: zeigt eine erste Ausführungsform des Drucksensors zur Messung des Absolutdrucks,
- Figur 2: zeigt einen Ausschnitt aus Figur 1, der den Signalwandlerbaustein auf dem Substrat des Drucksensors zeigt,
- Figur 3: zeigt eine weitere Ausführungsform des Drucksensors zur Messung des Relativdrucks,
- Figur 4: zeigt eine weitere Ausführungsform des Drucksensors zur Messung des Differenzdrucks.

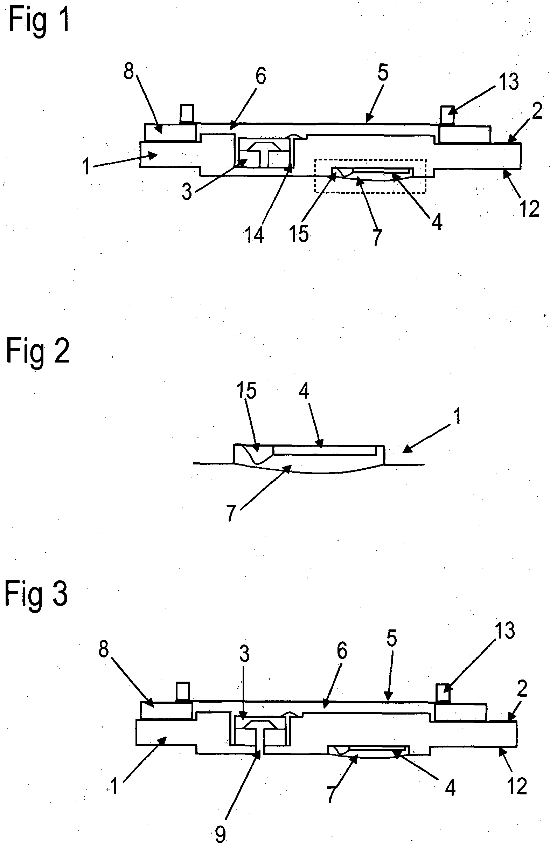

In der Figur 1 ist eine erste Ausführungsform des Drucksensors gezeigt, der ein Substrat 1 aus Keramik umfasst.
In einer ersten Vertiefung 14 des Substrats ist ein Messelement 3 angeordnet, das über Bonddrähte beziehungsweise mittels Leiterbahnen 2, die auf dem Substrat 1 aufgebracht sind, elektrisch kontaktiert ist. Das Messelement 3 weist vorzugsweise mit einer aktiven Seite einen direkten Kontakt zu einem ersten Hohlraum 6 auf. Der erste Hohlraum 6 wird durch das Substrat 1, eine Zwischenschicht 8 und eine erste Membran 5 gebildet. Die Zwischenschicht 8 weist vorzugsweise einen Wärmeausdehnungskoeffizienten auf, der an den Wärmeausdehnungskoeffizienten des Substrats 1 angepasst ist. Der erste Hohlraum 6 ist vorzugsweise mit einem inerten Füllmedium, wie beispielsweise Öl, gefüllt.

Auf der dem ersten Hohlraum 6 gegenüberliegenden Seite des Substrats 1 ist in einer zweiten Vertiefung 15 des Substrats 1 ein Signalwandler 4 angeordnet. Der Signalwandler 4 liegt vorzugsweise in Form eines ungehäusten Siliziumchips mit integrierten Schaltkreisen vor. Der Signalwandler 4 ist mittels Bonddrähten mit Leiterbahnen 2 des Substrats 1 kontaktiert.

Um den Signalwandler 4 vor mechanischen Beschädigungen und schädlichen Umwelteinflüssen beziehungsweise vor Korrosion durch die Umgebungsluft des Drucksensors zu schützen, ist der Signalwandler 4 mittels einer beispielsweise weichelastischen Masse 7 umhüllt.

Zum Anschluss des Drucksensors an ein mediengefülltes Rohr, dessen Druck ermittelt werden soll, weist der Drucksensor über der ersten Membran 5 einen Anschluss 13 auf. Der Anschluss 13 kann die Form eines Rohres, eine Gewindeanschlusses, einer Tülle oder die Form einer so genannten Schlaucholive aufweisen. Der Druck des Mediums hat somit über die erste Membran 5 und das inerte Füllmedium des ersten Hohlraums 6 einen direkten Kontakt zu dem Messelement 3 des Drucksensors.

Der Signalwandler 4 kann in einer weiteren möglichen Ausführungsform auch auf der Seite des Substrats 1 angeordnet sein, auf der der erste Hohlraum 6 angeordnet ist. Hierbei ist der Signalwandler 4 durch das inerte Füllmedium des ersten Hohlraumes 6 umgeben und ist so vor Korrosion beziehungsweise Umwelteinflüssen geschützt. In dieser Ausführungsform ist somit ein weiteres elastisches Material 7 zum Schutz des Signalwandlers 4 nicht erforderlich. Die Funktion des elastischen Materials wird hierbei bereits von dem inerten Füllmedium des ersten Hohlraumes 6 übernommen.

In Figur 2 ist ein Ausschnitt der Figur 1 dargestellt, der zeigt, wie der Signalwandler 4 in einer zweiten Vertiefung 15 des Substrats 1 angeordnet ist. Der Signalwandler 4, der in Form eines ungehäusten Siliziumchips vorliegt, ist mittels Bonddrähten mit Leiterbahnen 2 des Substrats 1 kontaktiert. Um das Silizium des Signalwandlers 4 vor mechanischen Beschädigungen und Korrosion oder anderweitigen Umwelteinflüssen zu schützen, ist der Signalwandler 4 zumindest teilweise mit einem elastischen Material 7 umhüllt. Der Signalwandler 4 liegt vorzugsweise direkt auf dem Substrat 1 auf. In der dargestellten Ausführungsform ist der Signalwandler 4 in einer zweiten Vertiefung 15 des Substrats 1 angeordnet, wobei das elastische Material 7 die zweite Vertiefung 15 in dem Substrat 1 auffüllt und somit den Signalwandler 4 vorzugsweise vollständig bedeckt. Dadurch ist der Signalwandler 4 gegenüber äußeren Einflüssen vor beispielsweise Korrosion geschützt. Das elastische Material 7 weist vorzugsweise eine geringe Härte auf, sodass sich der Signalwandler 4 bei Erwärmung des Drucksensors ausdehnen kann, ohne dass des zu schädlichen Verspannungen des Signalwandlers 4 kommen kann.

Die Figur 3 zeigt eine weitere Ausführungsform des Drucksensors zur Ermittlung des Relativdrucks eines Mediums. Zur Messung des Relativdrucks eines Mediums bezüglich der umgebenden Atmosphäre weist das Messelement 3 des Drucksensors über eine zweite Seite des Messelements 3 einen direkten Kontakt zur Atmosphäre auf. Hierzu weist das Substrat 1 des Drucksensors einen Durchbruch 9 auf, sodass ein direkter Kontakt des Messelements 3 beispielsweise zur Luftatmosphäre gegeben ist. Über eine erste Seite des Messelements 3 weist das Messelement 3 einen direkten Kontakt zu einem ersten Hohlraum 6 des Drucksensors auf. Der erste Hohlraum 6 weist somit über die erste Membran 5 einen Kontakt zu dem zu messenden Medium auf und ist vorzugsweise mittels des Messelements 3 von der den Drucksensor umgebenden Atmosphäre getrennt. Durch diese Anordnung kann der Druck eines Mediums, das auf die erste Membran 5 des Drucksensors einwirkt, gegenüber dem Atmosphärendruck der Umgebung des Drucksensors ermittelt werden.

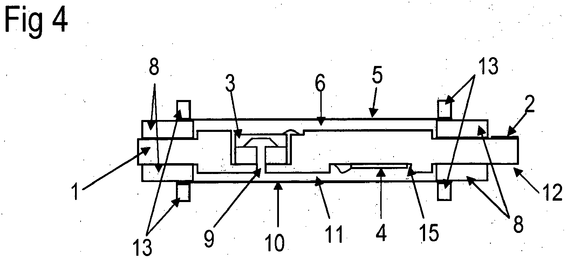

In der Figur 4 ist eine weitere Ausführungsform des Drucksensors dargestellt, der zur Messung des Differenzdrucks zwischen zwei Medien dient, die beide an dem Drucksensor anliegen. Das Substrat 1 des Drucksensors weist hierzu zwei voneinander getrennte Hohlräume 6, 11 auf, wobei das Messelement 3 mit einer aktiven Seite einen direkten Kontakt zu dem ersten Hohlraum 6 aufweist und mit einer zweiten Seite über einen Durchbruch 9 im Substrat 1 einen direkten Kontakt zu dem zweiten Hohlraum 11 aufweist. Der erste 6 und zweite 11 Hohlraum des Drucksensors sind jeweils mit inerten Füllmedien gefüllt.

In der dargestellten Ausführungsform ist in einer zweiten Vertiefung 15 auf der Unterseite des Substrats 1 ein Signalwandler 4 angeordnet. Der Signalwandler 4 ist vorzugsweise teilweise von dem Füllmedium des zweiten Hohlraums 11 umgeben. In der in Figur 4 dargestellten Ausführungsform des Drucksensors ist der Signalwandler nicht von einem zusätzlichen vorzugsweise weichelastischen Material zum Schutz vor Umwelteinflüssen umhüllt. Die Aufgabe, den Signalwandler 4 vor Korrosion beziehungsweise Umwelteinflüssen zu schützen, wird hierbei von dem Füllmedium des zweiten Hohlraums 11 übernommen.

Durch die Integration eines ungehäusten Signalwandlers in einer Vertiefung des Substrats beziehungsweise auf dem Substrat oder in dem mit einem inerten Füllmedium gefüllten Hohlraum wird eine größtmögliche Integration des Drucksensors erreicht. Durch eine größtmögliche Funktionsintegration des Messelements und des Signalwandlers in dem Drucksensor ist somit eine minimale Abmessung des Drucksensors erreichbar, wobei die Qualität der Werkstoffe in Bezug auf die Temperatur und Druckhysterese als wichtige Kenngrößen für den Sensorbau gegenüber konventionellen Konstruktionen mindestens gleich bleiben. Durch die kurzen Wege der Signalleitung wird die Verfälschung des eingeleiteten Drucks und die Einkopplung von elektrischen Signalstörungen reduziert, wobei durch die Integration aller Funktionen in das Sensorgehäuse die Herstellungskosten des Drucksensors deutlich reduziert werden können.

Es ist prinzipiell möglich, die Form des Drucksensors an gewünschte Einsatzbereiche anzupassen oder durch die Wahl von Form und Eigenschaften des Messelements beziehungsweise des Signalwandlers den Drucksensor an die geforderten Spezifikationen anzupassen.

### Bezugszeichenliste

- 1: Substrat
- 2: Leiterbahn
- 3: Messelement
- 4: Signalwandler
- 5: erste Membran
- 6: erster Hohlraum
- 7: elastisches Material
- 8: Zwischenschicht
- 9: Durchbruch
- 10: zweite Membran
- 11: zweiter Hohlraum
- 12: Kontaktbereich
- 13: Anschluss
- 14: erste Vertiefung
- 15: zweite Vertiefung

## Patentansprüche

1. Drucksensor, aufweisend
- ein Substrat (1), das eine Keramik umfasst, wobei das Substrat (1) Leiterbahnen (2) zur Kontaktierung von elektrischen Bauelementen (3, 4) aufweist,
- ein Messelement (3) zur Umwandlung einer mechanischen Messgröße in ein elektrisches Signal,
- einen Signalwandler (4) zur weiteren Verarbeitung der elektrischen Signale des Messelements (3),
- eine erste Membran (5), die ein Metall umfasst, wobei die Membran (5) zusammen mit dem Substrat (1) und einer Zwischenschicht (8) einen ersten geschlossenen Hohlraum (6) bildet, der ein inertes Füllmedium enthält,
- wobei das Messelement (3) mit wenigstens einer Seite, die eine aktive Fläche umfasst, einen direkten Kontakt zu dem Füllmedium des ersten Hohlraums (6) aufweist,
- wobei der Signalwandler (4) als ungehäuster integrierter Schaltkreis auf dem Substrat (1) angeordnet ist,
- und die Zwischenschicht (8) in Teilbereichen zwischen der ersten Membran (5) und dem Substrat (1) angeordnet ist, mit ihrem Wärmeausdehnungskoeffizienten an den Wärmeausdehnungskoeffizienten des Substrats (1) angepasst ist und Metalllegierungen (Kovar) enthält, die einen geringen Wärmeausdehnungskoeffizienten aufweisen, der typischerweise geringer ist als der Koeffizient der meisten Metalle.

2. Drucksensor nach Anspruch 1, wobei der Signalwandler (4) in einer zweiten Vertiefung (15) des Substrats angeordnet ist.

3. Drucksensor nach einem der vorhergehenden Ansprüche, wobei der Signalwandler (4) wenigstens teilweise von einem elastischen Material (7) umhüllt ist.

4. Drucksensor nach einem der vorhergehenden Ansprüche, wobei der Signalwandler (4) wenigstens teilweise einen direkten Kontakt zu dem Füllmedium aufweist.

5. Drucksensor nach einem der vorhergehenden Ansprüche, wobei die Zwischenschicht (8) die Form eines Rings aufweist.

6. Drucksensor nach einem der vorhergehenden Ansprüche, wobei das Messelement (3) mit seiner Rückseite einen direkten Kontakt zu der Umgebungsatmosphäre aufweist.

7. Drucksensor nach einem der Ansprüche 1 bis 5, wobei das Substrat (1) mittels einer zweiten Membran (10) einen zweiten geschlossenen Hohlraum (11) bildet, der ein inertes Füllmedium enthält, wobei der erste (6) und zweite (11) Hohlraum auf der gegenüberliegenden Seite des Substrats (1) angeordnet sind.

8. Drucksensor nach einem Anspruch 7, wobei das Messelement (3) mit seiner Rückseite einen direkten Kontakt zu dem Füllmedium des zweiten Hohlraums (11) aufweist.

9. Drucksensor nach einem der vorhergehenden Ansprüche, wobei das Messelement (3) und der Signalwandler (4) über die Leiterbahnen (2) des Substrats (1) kontaktiert sind.

10. Drucksensor nach einem der vorhergehenden Ansprüche, wobei die Leiterbahnen (2) des Substrats (1) wenigstens einen Bereich (12) aufweisen, der außerhalb des ersten (6) und/oder zweiten (11) Hohlraums angeordnet ist und von außen kontaktierbar ist.

11. Drucksensor nach einem der vorhergehenden Ansprüche, wobei der Drucksensor wenigstens an einer Seite einen rohrförmigen Anschluss (13) zur weiteren Befestigung des Drucksensors aufweist.

12. Drucksensor nach Anspruch 11, wobei der Anschluss (13) wenigstens teilweise auf der ersten (5) und/oder zweiten (10) Membran angeordnet ist.

13. Drucksensor nach einem der vorherigen Ansprüche, wobei die Membran mittels Löten oder Schweißen mit der Zwischenschicht verbunden ist.

14. Drucksensor nach einem der Ansprüche 7 oder 8, wobei der Signalwandler (4) im zweiten Hohlraum (11) angeordnet ist und zumindest teilweise vom Füllmedium des zweiten Hohlraums (11) umgeben ist.

## Claims

1. Pressure sensor having
- a substrate (1) which comprises a ceramic, the substrate (1) having conductor tracks (2) for contact-connecting electrical components (3, 4),
- a measuring element (3) for converting a mechanical measurement variable into an electrical signal,
- a signal converter (4) for processing the electrical signals from the measuring element (3) further,
- a first diaphragm (5) which comprises a metal, the diaphragm (5), together with the substrate (1) and an intermediate layer (8), forming a first closed cavity (6) which contains an inert filling medium,
- at least one side of the measuring element (3), which comprises an active surface, having direct contact with the filling medium in the first cavity (6),
- the signal converter (4) being arranged on the substrate (1) in the form of an unhoused integrated circuit,
- and the intermediate layer (8) being arranged in sections between the first diaphragm (5) and the substrate (1), the coefficient of thermal expansion of said intermediate layer being matched to the coefficient of thermal expansion of the substrate (1), and containing metal alloys (Kovar) which have a low coefficient of thermal expansion which is typically lower than the coefficient of most metals.

2. Pressure sensor according to Claim 1, the signal converter (4) being arranged in a second depression (15) of the substrate.

3. Pressure sensor according to one of the preceding claims, the signal converter (4) being at least partially encased by an elastic material (7).

4. Pressure sensor according to one of the preceding claims, the signal converter (4) at least partially having direct contact with the filling medium.

5. Pressure sensor according to one of the preceding claims, the intermediate layer (8) being in the form of a ring.

6. Pressure sensor according to one of the preceding claims, the rear side of the measuring element (3) having direct contact with the ambient atmosphere.

7. Pressure sensor according to one of Claims 1 to 5, the substrate (1) using a second diaphragm (10) to form a second closed cavity (11) which contains an inert filling medium, the first cavity (6) and the second cavity (11) being arranged on the opposite side of the substrate (1).

8. Pressure sensor according to Claim 7, the rear side of the measuring element (3) having direct contact with the filling medium in the second cavity (11).

9. Pressure sensor according to one of the preceding claims, the measuring element (3) and the signal converter (4) being contact-connected via the conductor tracks (2) of the substrate (1).

10. Pressure sensor according to one of the preceding claims, the conductor tracks (2) of the substrate (1) having at least one area (12) which is arranged outside the first cavity (6) and/or second cavity (11) and can be contact-connected from the outside.

11. Pressure sensor according to one of the preceding claims, the pressure sensor having, at least on one side, a tubular connection (13) for additionally fastening the pressure sensor.

12. Pressure sensor according to Claim 11, the connection (13) being at least partially arranged on the first diaphragm (5) and/or second diaphragm (10).

13. Pressure sensor according to one of the preceding claims, the diaphragm being connected to the intermediate layer by soldering or welding.

14. Pressure sensor according to either of Claims 7 and 8, the signal converter (4) being arranged in the second cavity (11) and being at least partially surrounded by the filling medium in the second cavity (11).

## Revendications

1. Capteur de pression, comportant
- un substrat (1) qui comporte une céramique, le substrat (1) comportant des pistes conductives (2) pour contacter des composants électriques (3, 4),
- un élément de mesure (3) pour convertir une grandeur de mesure mécanique en un signal électrique,
- un convertisseur de signal (4), pour le traitement ultérieur des signaux électriques de l'élément de mesure (3),
- une première membrane (5) qui comprend un métal, la membrane (5) formant en commun avec le substrat (1) et une couche intermédiaire (8) une première cavité (6) close qui contient un agent de remplissage inerte,
- par au moins un côté qui comprend une surface active, l'élément de mesure (3) comportant un contact direct avec l'agent de remplissage de la première cavité (6),
- le convertisseur de signal (4) étant placé en tant que circuit de commutation intégré sans boîtier sur le substrat (1),
- et la couche intermédiaire (8) étant placée dans des zones partielles entre la première membrane (5) et le substrat (1), par ses coefficients de dilatation thermique étant adaptée aux coefficients de dilatation thermique du substrat (1) et contenant des alliages métalliques (kovar) qui présentent un faible coefficient de dilatation thermique qui est typiquement inférieur au coefficient de la plupart des métaux.

2. Capteur de pression selon la revendication 1, le convertisseur de signal (4) étant placé dans un deuxième creux (15) du substrat.

3. Capteur de pression selon l'une quelconque des revendications précédentes, le convertisseur de signal (4) étant enveloppé au moins en partie par une matière élastique (7).

4. Capteur de pression selon l'une quelconque des revendications précédentes, le convertisseur de signal (4) comportant au moins en partie un contact direct avec l'agent de remplissage.

5. Capteur de pression selon l'une quelconque des revendications précédentes, la couche intermédiaire (8) présentant la forme d'un anneau.

6. Capteur de pression selon l'une quelconque des revendications précédentes, par sa face arrière, l'élément de mesure (3) comportant un contact direct avec l'atmosphère ambiante.

7. Capteur de pression selon l'une quelconque des revendications 1 à 5, à l'aide d'une deuxième membrane (10), le substrat (1) formant une deuxième cavité (11) close qui contient un agent de remplissage inerte, la première (6) et la deuxième (11) cavités étant placées sur la face opposée du substrat (1).

8. Capteur de pression selon une revendication 7, l'élément de mesure (3) présentant au niveau de sa face arrière un contact direct avec l'agent de remplissage de la deuxième cavité (11).

9. Capteur de pression selon l'une quelconque des revendications précédentes, l'élément de mesure (3) et le convertisseur de signal (4) étant contactés par l'intermédiaire des pistes conductives (2) du substrat (1).

10. Capteur de pression selon l'une quelconque des revendications précédentes, les pistes conductives (2) du substrat (1) comportant au moins une zone (12) qui est placée à l'extérieur de la première (6) et/ou de la deuxième (11) cavité et qui est susceptible d'être contactée par l'extérieur.

11. Capteur de pression selon l'une quelconque des revendications précédentes, le capteur de pression comportant, au moins sur une face, un raccord (13) de forme tubulaire, pour la fixation ultérieure du capteur de pression.

12. Capteur de pression selon la revendication 11, le raccord (13) étant placé au moins en partie sur la première (5) et/ou sur la deuxième (10) membrane.

13. Capteur de pression selon l'une quelconque des revendications précédentes, la membrane étant reliée par brasage ou par soudage avec la couche intermédiaire.

14. Capteur de pression selon l'une quelconque des revendications 7 ou 8, le convertisseur de signal (4) étant placé dans la deuxième cavité (11) et étant entouré au moins en partie par l'agent de remplissage de la deuxième cavité (11).
